# EUROPEAN PATENT APPLICATION

(11) **EP 3 706 163 A1**
(43) Date of publication of application: **09.09.2020**
(21) Application number: 18884405.4
(22) Date of filing: 23.11.2018
(51) Int. Cl.: H01L 23/043, H01L 23/31, H01L 23/367

(54) **PACKAGING STRUCTURE AND COMMUNICATION DEVICE**

(30) Priority: 30.11.2017 CN 201711254631
(71) Applicant: Huawei Technologies Co., Ltd., Longgang District Shenzhen, Guangdong 518129 (CN)
(72) Inventor: CHEN, Kairong, Shenzhen Guangdong 518129 (CN); ZHANG, Zongmin, Shenzhen Guangdong 518129 (CN); CAO, Mengyi, Shenzhen Guangdong 518129 (CN)
(74) Representative: Goddar, Heinz J.
(86) International application number: PCT/CN2018/117166
(87) International publication number: WO 2019/105295

(57) **Abstract**

Embodiments of the present invention disclose a package structure and a communications device. The package structure includes a substrate, a chip, a bonding layer, and a coating. A plurality of grooves are disposed on the substrate. Silver bonding materials are disposed in the plurality of grooves and on a surface of the substrate, to form the bonding layer. The chip is connected to the substrate by using the bonding layer. The plurality of grooves are symmetrically arranged along a first axis of symmetry and a second axis of symmetry that are perpendicular to each other, a vertical projection of the chip on the substrate is centrosymmetric about the first axis of symmetry and the second axis of symmetry, a groove in the plurality of grooves that faces a periphery of the chip is an outer-ring groove, and the vertical projection of the chip on the substrate covers a partial area of the outer-ring groove. The coating covers a surface that is of the bonding layer and that is not in contact with the substrate or the chip, and is used to prevent migration of silver ions in the bonding layer. The package structure provided in the embodiments of the present invention has an advantage of low thermal resistance and good heat dissipation efficiency, thereby prolonging a service life of a power amplifier.

## Description

This application claims priority to Chinese Patent Application No. 201711254631.6, filed with the Chinese Patent Office on November 30, 2017, and entitled "PACKAGE STRUCTURE AND COMMUNICATIONS DEVICE", which is incorporated herein by reference in its entirety.

### TECHNICAL FIELD

The present invention relates to the field of radio frequency power amplifier technologies, and in particular, to a package structure.

### BACKGROUND

A power amplifier is a core component of a base station (especially a macro base station), and performs a function of power amplification. With evolution of technologies, output power of the macro base station gradually increases, and a size of the macro base station continuously decreases. Therefore, power density of modules of the base station becomes higher, and consequently, junction temperature of the power amplifier continuously increases. In a package structure of the power amplifier, a chip is packaged onto a metal flange. How to reduce thermal resistance between the chip and the metal flange to improve heat dissipation efficiency is a direction under continuous research in the industry.

### SUMMARY

The embodiments of the present invention provide a package structure and a communications device to resolve a technical problem, so that a package solution with low thermal resistance is implemented, thereby ensuring good heat dissipation efficiency of the package structure.

According to a first aspect, in an implementation, an embodiment of the present invention provides a package structure, including a substrate, a chip, a bonding layer, and a coating. A plurality of grooves are disposed on the substrate. Silver bonding materials are disposed in the plurality of grooves and on a surface of the substrate, to form the bonding layer. The chip is connected to the substrate by using the bonding layer. The plurality of grooves are symmetrically arranged along a first axis of symmetry and a second axis of symmetry that are perpendicular to each other, a vertical projection of the chip on the substrate is centrosymmetric about the first axis of symmetry and the second axis of symmetry, a groove in the plurality of grooves that faces a periphery of the chip is an outer-ring groove, and the vertical projection of the chip on the substrate covers a partial area of the outer-ring groove. The coating covers a surface that is of the bonding layer and that is not in contact with the substrate or the chip, and is used to prevent migration of silver ions in the bonding layer.

In this embodiment, the silver bonding materials are used to form the bonding layer, so that heat conductivity can be very high, thereby better meeting a heat dissipation requirement of a high-power component. In addition, stress of the silver bonding layer can be relieved by using the plurality of specially disposed grooves, and the coating is used to prevent migration of the silver ions, so that this solution is highly valuable in terms of engineering implementation.

In an implementation of this application, the bonding layer is even in thickness, and being even in thickness means that the silver bonding materials that are symmetrically distributed along the first axis of symmetry and the second axis of symmetry are the same in thickness. The bonding layer is even in thickness, so that stress can be better evenly dispersed, thereby better reducing stratification or cracking of the bonding layer.

Specifically, that the bonding layer is even in thickness includes: a bonding material that is of the bonding layer and that is located in a vertical projection area of the chip is even in thickness; and a bonding material that is of the bonding layer and that is on a side of the chip is even in climbing height. In this implementation, the bonding layer is specifically divided to form an architecture with two parts that are even in thickness, so that stability and reliability of a connection between the chip and the substrate can be improved.

In an implementation of the first aspect, a dimension of the bonding layer in a direction perpendicular to the substrate is at least 25 µm. In this implementation, the thickness of the bonding layer is restricted, so that a reliability problem such as stratification or cracking of the bonding layer can be resolved.

In an implementation of the first aspect, the chip includes a top surface, a bottom surface, and a side surface connecting the top surface to the bottom surface, the side surface includes a step surface, the coating covers the step surface, and the step surface is used to increase a coverage area of the coating and prolong a migration path of the silver ions in the bonding layer.

In an implementation of the first aspect, a size of the top surface is less than a size of the bottom surface, the step surface faces the top surface, and a vertical distance between the top surface and the bottom surface is greater than 1 µm.

In an implementation of the first aspect, a size of the top surface is greater than a size of the bottom surface, the step surface faces the substrate, and a vertical distance between the top surface and the bottom surface is greater than 1 µm. In this application, the vertical distance between the top surface and the bottom surface is restricted to a value greater than 1 µm, to better help prevent the silver ions from migrating to the top surface, thereby improving reliability.

In an implementation of the first aspect, the package structure further includes a pin configured to connect to an external circuit, the chip is electrically connected to the pin by using a bonding wire, the pin includes a gate electrode and a drain electrode, and the gate electrode and the drain electrode are respectively located on two opposite sides of the package structure. Specifically, the package structure further includes a cover, and the cover is connected to the substrate. The cover and the substrate jointly form accommodation space, the chip is accommodated in the accommodation space, and the pin protrudes from the cover. In this implementation, a specific package structure is specified, thereby achieving beneficial effects of good heat dissipation efficiency and structure stability.

The cover is a ceramic cover, and the substrate is a metal substrate.

In an implementation of the first aspect, an auxiliary coating is further disposed on the surface of the substrate, the auxiliary coating is disposed on an extension path between the bonding layer and the pin, and the coating is located between the auxiliary coating and the bonding layer. The auxiliary coating is used to further prevent, with the help of the coating, the silver ions in the bonding layer from migrating to the pin along the extension path between the bonding layer and the pin. Specifically, an insulation layer is saliently disposed on the surface of the substrate, and the pin is disposed on the insulation layer. The auxiliary coating is located at a junction of an inner surface of the insulation layer and the substrate.

A height of the pin relative to the substrate is the same as the height of the top surface of the chip relative to the substrate, or a height of the pin relative to the substrate is greater than a height of the top surface of the chip relative to the substrate.

In this application, the chip does not cover the entire outer-ring groove, so that during installation of the chip, both a corner and a side of the chip can be covered by a bonding material. In this way, stratification or cracking of the bonding layer can be better prevented. Specific distribution manners of outer-ring grooves include the following four specific implementations.

In an implementation, there are a plurality of outer-ring grooves, the vertical projection of the chip on the substrate is a quadrilateral, and each side of the quadrilateral corresponds to at least three outer-ring grooves.

In an implementation, sizes of grooves corresponding to four angles of the quadrilateral each are greater than a size of another groove in the outer-ring grooves.

In an implementation, there are four outer-ring grooves, the vertical projection of the chip on the substrate is a quadrilateral, and the outer-ring grooves respectively correspond to four angles of the quadrilateral.

In an implementation, the groove corresponding to a central area of the chip is a central groove, the outer-ring groove is an annular groove, and the annular groove surrounds the central groove.

In this application, different distribution manners of the outer-ring grooves may be selected based on different chip sizes. For example, when a chip size is relatively small, an implementation in which there are four outer-ring grooves may be selected. If a chip size is relatively large, an implementation in which the outer-ring groove is an annular groove may be selected.

In an implementation of the first aspect, a depth of each groove is at least 5 µm, and the depth of the groove is an extension dimension of the groove in a direction perpendicular to the installation surface. The depth of the groove is set, to help reduce stress of the bonding layer and better reduce thermal resistance of the package structure, thereby improving heat dissipation efficiency.

In an implementation of the first aspect, a distance between adjacent grooves is 100 µm to 200 µm. In this embodiment, a range of the distance between adjacent grooves is set, to match chips of a plurality of sizes, and therefore good adaptability is achieved.

In the present invention, the groove is disposed on the substrate, to increase a contact area between the bonding layer and the substrate, and increase the thickness of the bonding layer, so that the bonding layer can release stress caused by thermal expansion, thereby avoiding stratification or cracking of the bonding layer.

According to a second aspect, an embodiment of the present invention provides a package structure, including a substrate, a chip, and a bonding layer, where
a plurality of grooves are disposed on a surface that is of the substrate and on which the chip is to be installed;
bonding materials are disposed in the plurality of grooves and on the surface of the substrate, to form the bonding layer, where heat conductivity of the bonding material is greater than 200 W/m·K;
the chip is connected to the substrate by using the bonding layer; and
the plurality of grooves are used to reduce and disperse stress of the bonding layer.

In this embodiment of the present invention, the heat conductivity of the bonding layer is greater than 200 W/m K, so that thermal resistance of the package structure is reduced, in other words, thermal resistance of a heat conduction path between the chip and the substrate is reduced, thereby improving heat dissipation efficiency.

In an implementation of the second aspect, the bonding layer is even in thickness, and being even in thickness means that the bonding materials that are symmetrically distributed along two axes of symmetry that are perpendicular to each other are the same in thickness.

Specifically, that the bonding layer is even in thickness includes:
a bonding material that is of the bonding layer and that is located in a vertical projection area of the chip is even in thickness; and
a bonding material that is of the bonding layer and that is on a side of the chip is even in climbing height.

In an implementation of the second aspect, the plurality of grooves are symmetrically arranged along one or more axes of symmetry, and one or more axes of symmetry of the chip installed on the installation surface are respectively aligned with the one or more axes of symmetry of the plurality of grooves.

In an implementation of the second aspect, the plurality of grooves are symmetrically arranged along a first axis of symmetry and a second axis of symmetry that are perpendicular to each other, a vertical projection of the chip on the substrate is centrosymmetric about the first axis of symmetry and the second axis of symmetry, a groove in the plurality of grooves that faces a periphery of the chip is an outer-ring groove, and the vertical projection of the chip on the substrate covers a partial area of the outer-ring groove.

In an implementation of the second aspect, the bonding material is a silver bonding material.

In an implementation of the second aspect, the package structure further includes a coating, and the coating covers a surface that is of the bonding layer and that is not in contact with the substrate or the chip, and is used to prevent migration of silver ions in the bonding layer.

In an implementation of the second aspect, a depth of each groove is at least 5 µm, and the depth of the groove is an extension dimension of the groove in a direction perpendicular to the installation surface.

In an implementation of the second aspect, a distance between adjacent grooves is 100 µm to 200 µm.

According to a third aspect, an embodiment of the present invention further provides a package structure, including a substrate, a chip, and a bonding layer, where
a plurality of grooves are disposed on a surface that is of the substrate and on which the chip is to be installed;
bonding materials are disposed in the plurality of grooves and on the surface of the substrate, to form the bonding layer, where heat conductivity of the bonding material is greater than 200 W/m·K;
the chip is connected to the substrate by using the bonding layer; and
the bonding layer is even in thickness.

In an implementation of the third aspect, that the bonding layer is even in thickness includes:
a bonding material that is of the bonding layer and that is located in a vertical projection area of the chip is even in thickness; and
a bonding material that is of the bonding layer and that is on a side of the chip is even in climbing height.

In an implementation of the third aspect, the plurality of grooves are symmetrically arranged along one or more axes of symmetry, and one or more axes of symmetry of the chip installed on the installation surface are respectively aligned with the one or more axes of symmetry of the plurality of grooves.

In an implementation of the third aspect, the plurality of grooves are symmetrically arranged along a first axis of symmetry and a second axis of symmetry that are perpendicular to each other, a vertical projection of the chip on the substrate is centrosymmetric about the first axis of symmetry and the second axis of symmetry, a groove in the plurality of grooves that faces a periphery of the chip is an outer-ring groove, and the vertical projection of the chip on the substrate covers a partial area of the outer-ring groove.

In an implementation of the third aspect, the bonding material is a silver bonding material.

In an implementation of the third aspect, the package structure further includes a coating, and the coating covers a surface that is of the bonding layer and that is not in contact with the substrate or the chip, and is used to prevent migration of silver ions in the bonding layer.

In an implementation of the third aspect, a depth of each groove is at least 5 µm, and the depth of the groove is an extension dimension of the groove in a direction perpendicular to the installation surface.

In an implementation of the third aspect, a distance between adjacent grooves is 100 µm to 200 µm.

In an implementation, the package structure provided in this embodiment of the present invention is a power amplifier.

According to a fourth aspect, an embodiment of the present invention provides a communications device, including a package structure, a small radio frequency component, and a radio frequency passive component, where the package structure is a power amplifier, and is connected between the radio frequency small signal component and the radio frequency passive component. The radio frequency small signal component includes a frequency mixer, an amplifier, and a filter. The frequency mixer is configured to receive an analog signal and increase signal frequency. The amplifier receives a signal transmitted by the frequency mixer, and amplifies power. The filter is configured to receive a signal transmitted by the amplifier, filter out an out-of-band signal, and transmit, to the power amplifier, a signal obtained after filtering. The radio frequency passive component includes an isolator, a filter, and an antenna. The isolator receives a signal from the power component, isolates an unnecessary signal to improve signal linearity, and transmits a signal to the filter for filtering. A signal obtained after filtering is transmitted to the antenna.

In an implementation of the fourth aspect, the communications device is a remote radio unit (RRU, Radio Remote Unit) in a base station.

According to a fifth aspect, this application further provides a package structure manufacture method, including the following steps:
A groove is disposed on a substrate, and an insulation layer and a pin are installed on the substrate.

A silver bonding material is disposed on the substrate to form a bonding layer, and a chip is bonded to the substrate by using the bonding layer.

A coating and an auxiliary coating are disposed. The coating covers a surface that is of the bonding layer and that is not in contact with the substrate or the chip, and is used to prevent migration of silver ions in the bonding layer that is caused because vapor enters the bonding layer. The auxiliary coating is disposed on an extension path between the bonding layer and the pin, and the coating is located between the auxiliary coating and the bonding layer. The auxiliary coating is used to further prevent, with the help of the coating, the silver ions in the bonding layer from migrating to the pin along the extension path between the bonding layer and the pin. Specifically, the auxiliary coating is located at a junction of an inner surface of the insulation layer and the substrate.

A bonding wire is disposed, to electrically connect the chip to the pin. Then, a cover is installed, and the cover is connected to the substrate. The cover and the substrate jointly form accommodation space, the chip is accommodated in the accommodation space, and the pin protrudes from the cover.

The power component in the embodiments of the present invention is applied to the base station, and is disposed between the radio frequency small signal component and the radio frequency passive component, to amplify a radio frequency signal. Design of the package structure can improve operating stability of the power amplifier and prolong a service life of the power amplifier.

### BRIEF DESCRIPTION OF DRAWINGS

To describe the technical solutions in the embodiments of the present invention or in the background more clearly, the following describes the accompanying drawings required for describing the embodiments of the present invention or the background.
FIG. 1 is an architectural diagram of a communications device according to an implementation of the present invention;
FIG. 2 is a schematic diagram showing that a groove is disposed on a substrate in a package structure according to an implementation of the present invention;
FIG. 3 is a schematic diagram showing that a chip is fastened, by using a bonding layer, to the substrate shown in FIG. 2;
FIG 4 is a schematic diagram showing that a coating and an auxiliary coating are disposed on a bonding layer of a package structure provided in an embodiment shown in FIG. 3;
FIG. 5 is a schematic diagram showing that a cover is disposed on a package structure shown in FIG. 4 according to an implementation of the present invention;
FIG. 6A is a schematic three-dimensional diagram of distribution of a chip and grooves in a package structure according to an implementation of the present invention;
FIG. 6B is a schematic three-dimensional diagram of distribution of grooves in a package structure when a chip is disposed on a substrate according to an implementation of the present invention;
FIG. 7, FIG. 8, FIG. 9, and FIG. 10 are schematic diagrams of four different arrangement manners of grooves disposed on a substrate in a package structure according to an embodiment of the present invention;
FIG. 11 is a schematic structural diagram of a chip, a bonding layer, a substrate, and a coating in a package structure according to an implementation of the present invention;
FIG. 12 is a schematic structural diagram of a chip, a bonding layer, a substrate, and a coating in a package structure according to another implementation of the present invention;
FIG. 13 is a curve diagram showing a thermal resistance test for comparing a package structure provided in the present invention with a package structure in the prior art; and
FIG. 14 is a schematic diagram of a power component according to an embodiment of the present invention.

### DESCRIPTION OF EMBODIMENTS

The following describes the embodiments of the present invention with reference to the accompanying drawings in the embodiments of the present invention.

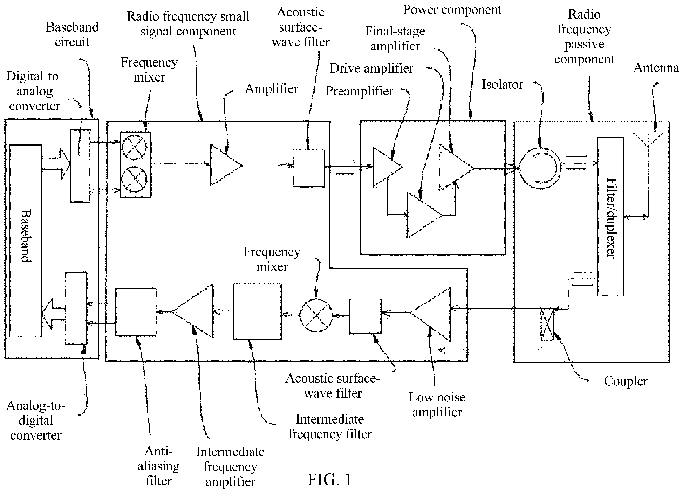

As shown in FIG. 1, a package structure provided in an embodiment of the present invention may be applied to a communications device. The communications device is a remote radio unit (RRU, Radio Remote Unit) in a base station. In an implementation, the package structure is a power amplifier. The power amplifier is applied to a power amplifier board of the base station. Four modules are disposed on the power amplifier board of the base station: a baseband circuit, a radio frequency small signal component, a power component (namely, the power amplifier), and a radio frequency passive component.

In the baseband circuit, a baseband (Baseband) is responsible for demodulating, descrambling, despreading, and decoding a radio signal in a mobile network, and transmitting a finally decoded digital signal to an upper-layer processing system for processing. The baseband is usually referred to as a BB, and the baseband may be understood as a communications module.

A flowing direction of a signal from the baseband to an antenna is specifically as follows: A digital-to-analog converter converts a signal (digital signal) in the baseband into an analog signal; a frequency mixer increases signal frequency of the analog signal; then an amplifier drives signal power to be amplified; and an acoustic surface-wave filter filters out an out-of-band signal from a signal that is output by the amplifier, to filter out most signals that do not belong to this broadband. A signal obtained after the filtering is transferred to the power component to drive the signal. Then, the signal is input into an isolator, and the isolator isolates an unnecessary signal, to improve signal linearity. Finally, a filter filters the signal for a last time, to ensure signal purity, and then sends, by using the antenna, a signal obtained after the filtering.

A flowing direction of a signal from the antenna to the baseband is specifically as follows: A signal received by the antenna is transmitted to a duplexer; then the signal is transmitted to a low noise amplifier by using a coupler; and after being sequentially transmitted to an acoustic surface-wave filter, a frequency mixer, an intermediate frequency filter, an intermediate frequency amplifier, and an anti-aliasing filter, a signal processed by the low noise amplifier is converted into a digital signal by an analog-to-digital converter, and then the digital signal is transmitted to the baseband.

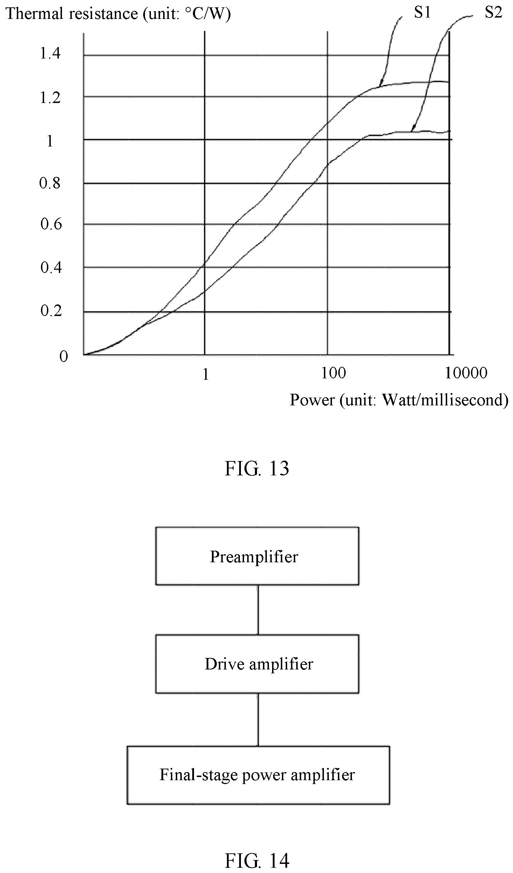

This embodiment of the present invention relates to a package structure and a communications device that has the package structure. The communications device is a remote radio unit (RRU, Radio Remote Unit) in a base station. The package structure is a power amplifier. A power component that performs a function of radio frequency signal amplification and that is located between the radio frequency small signal component and the radio frequency passive component on the power amplifier board of the base station shown in FIG. 1 includes the package structure provided in this application. Referring to FIG. 1 and FIG. 14, the power component may specifically include a preamplifier, a drive amplifier, and a final-stage power amplifier that are disposed in sequence. The drive amplifier is connected between the preamplifier and the final-stage power amplifier, and is configured to receive a current signal sent by the preamplifier, and further amplify the current signal into a signal of medium power, to drive the final-stage power amplifier to run normally. The package structure in this embodiment may be applied to any power amplifier. In practice, the final-stage power amplifier has a larger heat dissipation requirement, and therefore the package structure in this application is more suitable for the final-stage power amplifier.

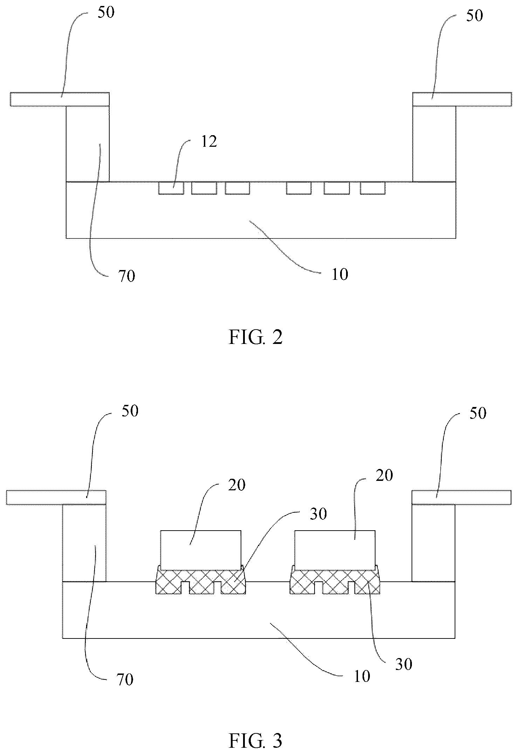

Referring to FIG. 2, FIG. 3, FIG. 4, and FIG. 5, in an implementation, the package structure includes a substrate 10, a chip 20 (also referred to as a die), and a bonding layer 30. The bonding layer 30 is used to fasten the chip 20 to a surface of the substrate 10. The substrate 10 is a metal substrate and has a heat-conducting property. In a specific embodiment, a material of the substrate 10 includes three layers of materials. Atop layer and a bottom layer are copper (Cu), and a middle layer is molybdenum (Mo), or the middle layer is copper-molybdenum alloy. A plurality of grooves 12 are disposed on an installation surface of the substrate 10. In an implementation, the plurality of grooves 12 are arranged in a matrix. In the implementation shown in FIG. 2 to FIG. 5, the installation surface (to be specific, a surface on which the chip 20 is installed) of the substrate 10 is an upper surface of the substrate 10. The chip 20 is connected to the installation surface by using the bonding layer 30, a part that is of the bonding layer 30 and that is combined with the installation surface is embedded into the plurality of grooves 12, a part that is of the bonding layer 30 and that is combined with the chip 20 wraps a surface that is of the chip 20 and that faces the substrate 10, and heat conductivity of the bonding layer 30 is greater than 200 W/m·K. In this embodiment, the heat conductivity of the bonding layer 30 is set to be greater than 200 W/m·K, so that thermal resistance of the package structure is reduced, in other words, thermal resistance of a heat conduction path between the chip 20 and the substrate 10 is reduced, thereby improving heat dissipation efficiency.

In this application, the plurality of grooves 12 are used to reduce and disperse stress of the bonding layer 30. To better reduce and disperse stress, the grooves may be arranged by using methods described in the following embodiments.

In an embodiment, the plurality of grooves 12 are symmetrically arranged along a first axis of symmetry and a second axis of symmetry that are perpendicular to each other, in other words, the plurality of grooves are symmetrically arranged with respect to both the first axis of symmetry and the second axis of symmetry. Two axes of symmetry that are perpendicular to each other, namely, a third axis of symmetry and a fourth axis of symmetry, of a shape of a vertical projection of the chip 20 that is formed on the installation surface after the chip 20 (in a rectangular shape) is installed on the installation surface respectively overlap the first axis of symmetry and the second axis of symmetry. In other words, the vertical projection of the chip 20 on the substrate 10 is centrosymmetric about the first axis of symmetry and the second axis of symmetry.

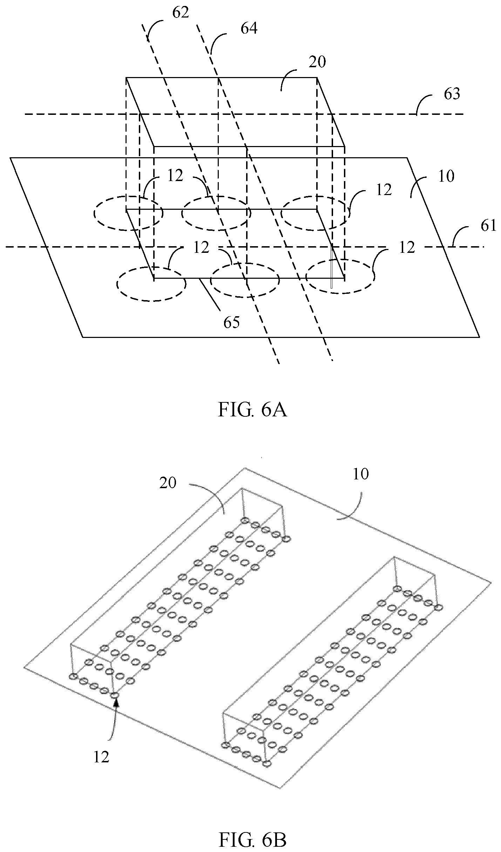

For example, referring to FIG. 6A, a plurality of grooves 12 are symmetrically arranged along a first axis of symmetry 61 and a second axis of symmetry 62. Axes of symmetry of the chip 20 are denoted as reference numerals 63 and 64 in the figure. A shape of a vertical projection of the chip 20 that is formed on the installation surface after the chip 20 is installed on the installation surface is a rectangle that is represented by using solid lines and that is denoted by a reference numeral 65 in the figure. Because the rectangle 65 is the vertical projection, axes of symmetry of the rectangle 65 are vertical projections of the axes of symmetry 63 and 64 of the chip on the installation surface. The vertical projection of the axis of symmetry 63 may be considered as the third axis of symmetry, and the vertical projection of the axis of symmetry 64 may be considered as the fourth axis of symmetry. Apparently, the third axis of symmetry (the vertical projection of the axis of symmetry 63) overlaps the first axis of symmetry (61), and the fourth axis of symmetry (the vertical projection of the axis of symmetry 64) overlaps the second axis of symmetry (62). It should be noted that, the third axis of symmetry and the fourth axis of symmetry respectively overlap the first axis of symmetry and the third axis of symmetry, and therefore the third axis of symmetry and the fourth axis of symmetry are not clearly marked in FIG. 6A.

FIG. 6B is a schematic three-dimensional diagram showing that the chip 20 is disposed on the substrate 10. It can be learned from FIG. 6B that a plurality of grooves 12 arranged in an array are disposed on the substrate 10. A location relationship between an outer-ring groove and a side and a corner of the chip 20 is as follows: The side and the corner of the chip 20 fall inside the outer-ring grooves 12, and cover parts of the outer-ring grooves 12. In other words, parts of the outer-ring grooves 12 are located outside an orthographic projection of the chip 20 on the substrate 10.

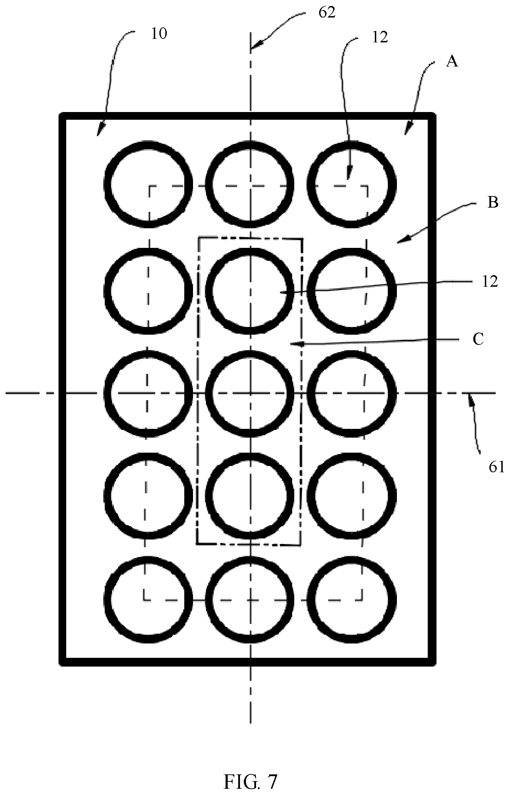

With reference to FIG. 7, FIG. 8, FIG. 9, and FIG. 10, a manner of disposing the grooves is specifically described below by using various embodiments.

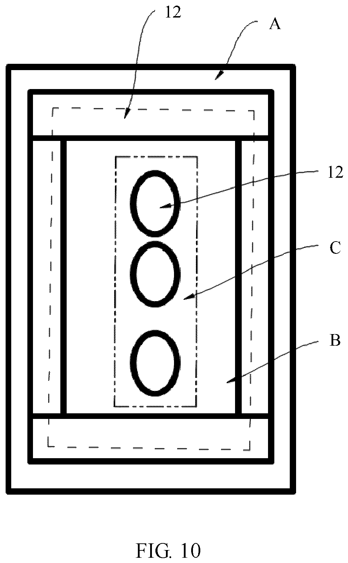

Referring to FIG. 7 to FIG. 10, a manner of distributing the grooves 12 on the substrate 10 is as follows: The grooves 12 are symmetrically arranged along a first axis of symmetry 61 and a second axis of symmetry 62 that are perpendicular to each other. The vertical projection of the chip 20 on the substrate 10 after the chip 20 is installed on the substrate 10 covers parts of outermost grooves 12. As shown in FIG. 7 and FIG. 10, an outer-ring dashed-line frame represents the vertical projection of the chip 20 on the substrate 10, and the vertical projection overlaps only a part of an area of the outer-ring groove 12.

Specifically, an area that is on the surface of the substrate 10 and on which the grooves 12 are disposed is an area A. The area A includes a central area C (that is, an area surrounded by dash-dot-dot lines in the figure) and a peripheral area B surrounding the central area C. The central area C is opposite to a central area of the chip 20, the peripheral area B is opposite to a periphery of the chip 20, the plurality of grooves 12 are arranged in the central area C and the peripheral area B, and a part of the groove 12 located in the peripheral area B is outside the vertical projection of the chip 20 on the installation surface (in other words, with reference to FIG. 3 to FIG. 5, a vertical projection of the chip 20 on an installation surface A falls inside the grooves 12). In other words, a groove 12 in the plurality of grooves 12 that is opposite to the periphery of the chip 20 is the outer-ring groove, the chip 20 does not cover the entire outer-ring groove 12, and the vertical projection of the chip 20 on the substrate 10 covers only a part of an area of the outer-ring groove 12. In other words, an effective area occupied by the groove 12 on the surface of the substrate 10 is greater than an effective area occupied by the chip 20 above the substrate 10. In this manner in which the outer-ring groove is not entirely covered, during installation of the chip, both the corner and the side of the chip can be covered by a bonding material. In this way, stratification or cracking of the bonding layer 30 can be better prevented.

Referring to FIG. 7, in an implementation, a size of the groove 12 (namely, the outer-ring groove) in the peripheral area B is the same as a size of the groove 12 in the central area C. The grooves 12 in the peripheral area B are arranged in a rectangle: Five grooves 12 are arranged on a longer side, and three grooves 12 are arranged on a shorter side. The grooves 12 in the central area C are arranged in a line. In other words, there are a plurality of outer-ring grooves 12, the vertical projection of the chip 20 on the substrate 10 is a quadrilateral, and each side of the quadrilateral corresponds to at least three outer-ring grooves 12.

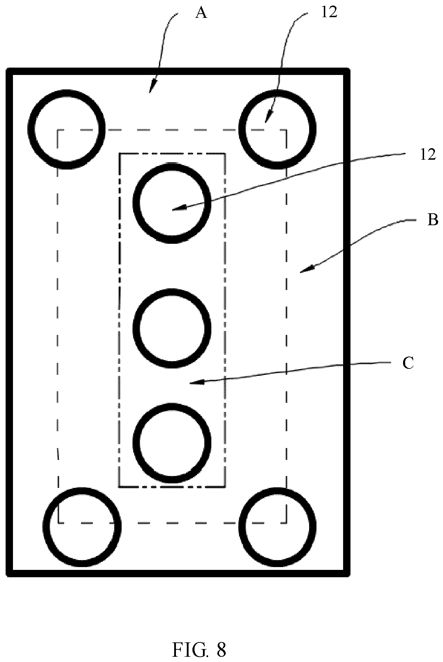

Referring to FIG. 8, in another implementation, there are four grooves 12 (namely, outer-ring grooves) in the peripheral area B, the four grooves are separately arranged in four corners of a rectangle, and the grooves 12 in the central area C are arranged in a line.

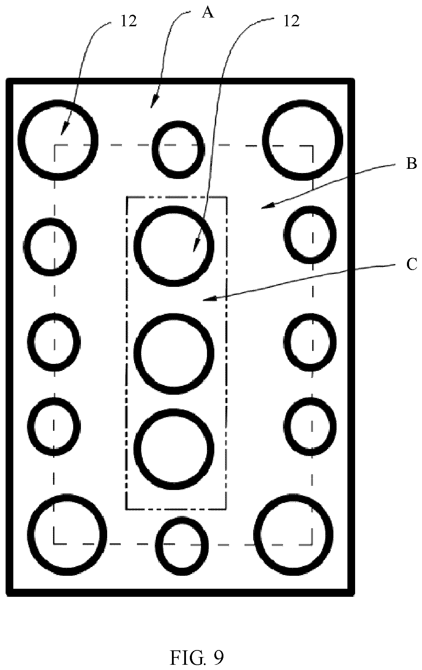

Referring to FIG. 9, in another implementation, sizes of grooves 12 corresponding to four angles of a quadrilateral each are greater than a size of another groove 12 in the peripheral area B. A diameter of a groove 12 with a small size is reduced to 100 µm ± 25 µm. The sizes of the grooves 12 corresponding to the four angles of the quadrilateral each are the same as a size of the groove 12 in the central area C, and the grooves 12 in the central area C are arranged in a line.

Referring to FIG. 10, in another implementation, the groove 12 in the peripheral area B is an annular groove, and the annular groove surrounds the groove 12 in the central area C. An area surrounded by the annular groove is a rectangular area. A width of the annular groove is 100 µm ± 25 µm.

In an implementation, a depth of each groove 12 is at least 5 µm and does not exceed a thickness of the substrate 10, and the depth of the groove 12 is an extension dimension of the groove 12 in a direction perpendicular to the installation surface.

In an implementation, a distance between adjacent grooves 12 is 100 µm to 200 µm.

Specifically, a shape of a single groove 12 may be a circle, a square, an ellipse, or another irregular shape; an area of the single groove 12 is 0.03 mm² to 0.07 mm²; the distance between adjacent grooves 12 is 100 µm to 200 µm; and the depth of each groove 12 is at least 5 µm. In an implementation, surface roughness Ra of an inner wall of each groove 12 is 0.1 to 0.2 µm.

In the present invention, the groove 12 is disposed on the substrate 10, to increase a contact area between the bonding layer 30 and the substrate 10, and increase a thickness of the bonding layer 30, so that the bonding layer 30 can release stress caused by thermal expansion, thereby avoiding stratification or cracking of the bonding layer 30.

In an implementation, the bonding layer 30 is even in thickness. A thickness of the bonding layer 30 includes two parts. One part is a thickness of the bonding layer 30 located between the substrate 10 and the chip 20 (namely, a dimension of the bonding layer 30 between the substrate 10 and the chip 20 in a direction perpendicular to the surface of the substrate 10). The other part is a climbing height of a bonding material that is of the bonding layer 30 and that is on a side of the chip 20. "Being even in thickness" means that bonding materials symmetrically distributed along two axes of symmetry that are perpendicular to each other (namely, the first axis of symmetry and the second axis of symmetry) are the same in thickness. In other words, a bonding material at a location needs to have a same thickness as not only a bonding material at a symmetric location of the location with respect to the first axis of symmetry but also a bonding material at a symmetric location of the location with respect to the second axis of symmetry. It should be noted that, due to a limitation of techniques, "evenness" herein cannot be absolute 100% evenness. A person skilled in the art may understand that "evenness" herein is evenness that can be implemented by using specific techniques, and an error is acceptable. To implement an even thickness, depths of grooves may be set to be the same, to avoid a case in which the bonding layer 30 is uneven in thickness because the grooves have different depths.

The bonding layer is even in thickness, so that stress can be better evenly dispersed, thereby better reducing stratification or cracking of the bonding layer.

In an implementation, the bonding layer 30 is made from silver (namely, nanoscale pure silver particles, where "pure silver" is silver that can be made as pure as possible by using existing techniques or silver that is made as pure as possible to approach purity in the prior art, and usually silver content is at least 99%), and a heat conduction path between the chip 20 and the substrate 10 is implemented through sintering and curing. In this embodiment, the bonding layer 30 is limited to a silver bonding material. The silver bonding material is sintered and cured between the chip 20 and the substrate 10 to conduct heat. Because the silver (namely, the pure silver) is used, thermal resistance is very low, and heat conductivity may exceed or approach 400 W/m·K. The silver bonding material has a better heat dissipation effect than another material (for example, another metal alloy or a silver alloy). In other embodiments, some other silver alloys with relatively low silver content, or other metals, or other materials with low thermal resistance are not limited.

Because of special material characteristics (a large coefficient of thermal expansion and low material density) of the silver bonding material, stratification of a silver layer and migration of silver ions may occur after cyclic humidity-heat-temperature tests. Stratification of the silver layer can be resolved in the various manners described above (for example, disposing the plurality of grooves, and being even in thickness). In addition, in another implementation, the thickness (namely, a dimension in a direction perpendicular to the substrate 10) of the silver bonding layer 30 between the substrate and the chip may alternatively be set to be within a range from 5 µm to 50 µm. In an embodiment, a range from 25 µm to 50 µm is used, so that mechanical stress caused by thermal expansion can be better released, thereby better resolving a reliability problem such as stratification or cracking of the bonding layer. A largest climbing height of the silver is less than 30% of a height of the chip (die) 20, and the height of the chip 20 is a dimension of the chip 20 in the direction perpendicular to the substrate 10.

To prevent migration of the silver ions, in an implementation, the package structure further includes a coating 40. The coating 40 covers a surface that is of the bonding layer 30 and that is not in contact with the substrate 10 or the chip 20, and is used to prevent migration of silver ions in the bonding layer 30 that is caused because vapor enters the bonding layer 30. Specifically, the coating 40 covers an entire surface of an exposed part of the bonding layer 30. A thickness of the coating 40 covered on the surface of the bonding layer 30 is at least 5 µm. In this implementation, the coating 40 is a material with high Tg (≥150°C), and has a high-waterproofing characteristic. In an implementation, the coating 40 is a cyclo olefin polymer.

In another implementation, the coating 40 may be a chemical coating. A material of the chemical coating needs to have high Tg (higher than junction temperature Tj of the chip 20) and a high-waterproofing characteristic, and a thickness of the chemical coating is within a range from 10 µm to 30 µm. In an implementation, the coating 40 is metal plating, a material of the metal plating may be Ni, Sn, or stainless steel, and a thickness of the metal plating is within a range from 5 µm to 10 µm.

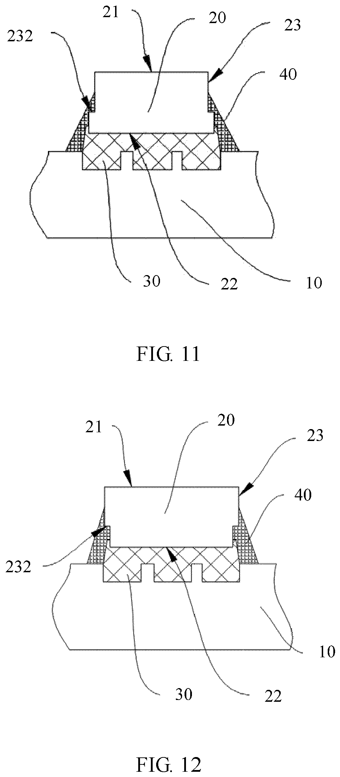

Referring to FIG. 11 and FIG. 12, in an implementation, the chip 20 includes a top surface 21, a bottom surface 22, and a side surface 23 connecting the top surface 21 to the bottom surface 22. The side surface 23 includes a step surface 232, the coating 40 covers the step surface 232, and the step surface 232 is used to increase a coverage area of the coating 40 and prolong a migration path of the silver ions in the bonding layer 30, to better suppress migration of the silver ions. A vertical distance between the substrate 10 and an edge of the coating 40 that is away from the substrate 10 is less than a vertical distance between the top surface of the chip 20 and the substrate 10.

The step surface 232 is formed by using a technique of performing cutting twice in a process of cutting the chip 20. A thick cutter is used during first cutting, a thin cutter is used during second cutting, and a thickness difference between the thick cutter and the thin cutter may be at least 2 µm.

In an implementation, as shown in FIG. 11, a size of the top surface 21 is less than a size of the bottom surface 22, the step surface 232 faces the top surface 21, and a vertical distance between the top surface 21 and the bottom surface 22 is greater than 1 µm.

In an implementation, as shown in FIG. 7, a size of the top surface 21 is greater than a size of the bottom surface 22, the step surface 232 faces the substrate 10, and a vertical distance between the top surface 21 and the bottom surface 22 is greater than 1 µm.

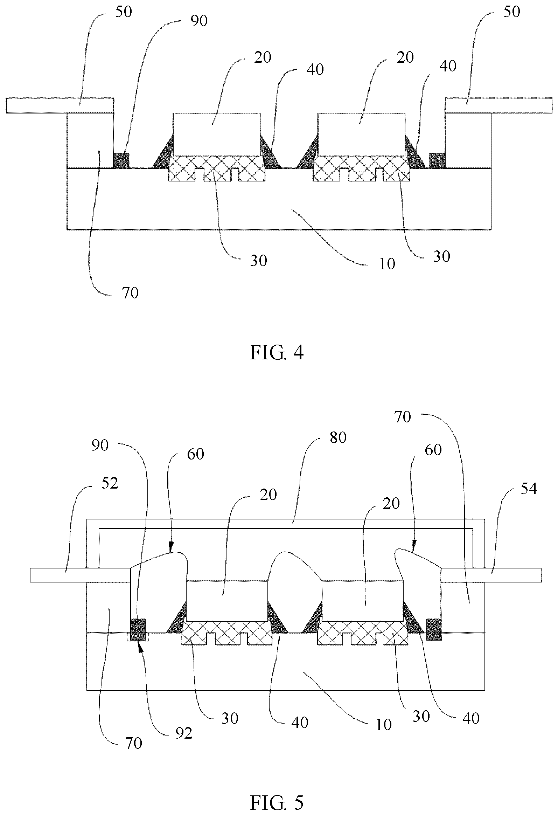

Referring to FIG. 4 and FIG. 5, in an implementation, the package structure further includes a pin 50 configured to connect to an external circuit, and the chip 20 is electrically connected to the pin 50 by using a bonding wire 60.

In an implementation, the pin 50 includes a gate electrode 52 and a drain electrode 54, and the gate electrode 52 and the drain electrode 54 are respectively located on two opposite sides of the package structure.

An insulation layer 70 is disposed between the pin 50 and the substrate 10, and the insulation layer 70 may be a ceramic material. The insulation layer 70 raises the pin 50, so that a height of the pin relative to the substrate 10 is close to a height of the top surface of the chip 20 relative to the substrate 10. Specifically, the height of the pin relative to the substrate 10 is the same as the height of the top surface of the chip 20 relative to the substrate 10, or the height of the pin relative to the substrate 10 is greater than the height of the top surface of the chip 20 relative to the substrate 10.

In an implementation, referring to FIG. 5, the package structure further includes a cover 80, and the cover 80 is connected to the substrate 10. The cover 80 and the substrate 10 jointly form accommodation space, the chip 20 is accommodated in the accommodation space, and the pin 50 protrudes from the cover 80.

The cover 80 may be a ceramic cover 80, and the substrate 10 may be a metal substrate.

Referring to FIG. 5, in another implementation, an auxiliary coating 90 is further disposed on the surface of the substrate 10, the auxiliary coating 90 is disposed on an extension path between the bonding layer 30 and the pin 50, and the coating 40 is disposed between the auxiliary coating 90 and the bonding layer 30. The auxiliary coating 90 is used to further prevent, with the help of the coating 40, the silver ions in the bonding layer 30 from migrating to the pin 50 along the extension path between the bonding layer 30 and the pin 50. Specifically, the auxiliary coating 90 is located at a junction of an inner surface of the insulation layer 70 and the substrate 10.

Referring to FIG. 5, in another implementation, a second groove 92 is disposed on the surface of the substrate 10. A part included in a dashed-line frame in FIG. 5 is the second groove 92, and the auxiliary coating 92 has been filled in the second groove 92 in FIG. 5. The second groove 92 is close to an inner wall of the insulation layer 70, and the auxiliary coating 90 is filled in the second groove 92 and protrudes from the second groove 92. The second groove 92 can reduce mechanical stress generated in a thermal expansion process of the substrate 10.

The package structure provided in the embodiments of the present invention is used for same power amplifiers, and a bonding layer 30 with heat conductivity greater than 200 W/m·K and a bonding material currently used in the industry are used, to measure thermal resistance data of the components. As shown in FIG. 13, specific test data is as follows: A curve S1 represents an AuSn bonding material currently used in the industry, and a test result is that thermal resistance of a component is 1.3 °C/W; and a curve S2 represents the bonding layer 30 (the Ag bonding layer) used in this application, and a test result is that thermal resistance of a component is 1.1 °C/W. Thermal resistance of the power amplifier is decreased by 15% when the solution of this application is used. A test method used in the foregoing test is as follows: A relationship indicating how channel temperature of a component changes with DC power consumption is tested by using a characteristic that forward voltage-drop of a parasitic diode of the component changes with temperature, to obtain thermal resistance of the component through calculation.

The package structure provided in the embodiments of the present invention can pass a high-temperature and high-humidity stress test, to determine whether the silver ions migrate. A process of confirming an effect of migration of the silver ions is as follows: Because the bonding layer 30 is covered by the coating 40, the bonding layer 30 can pass a HAST (highly accelerated stress test, Highly Accelerated Stress Test) and the high-temperature and high-humidity stress test. Details are as follows:
(1) A quantity of samples: 20 pcs
(2) Test conditions: 135°C (temperature) + 85% (humidity) + 33.3 Psi (atmospheric pressure) + 96 hours
(3) Test judgment criterion: Using an instrument to observe whether silver ions migrate.
(4) Result: A device without protection from the coating 40 cannot pass a reliability test, namely, the HAST; and a device with protection from the coating 40 can pass HAST tests a plurality of times.

The embodiments of the present invention can also pass an application emulation test.

### (1) Stress emulation tests of bonding layers 30 (silver bonding materials) with different thicknesses

Two different materials are sintered with Ag, to perform stress emulation in different thicknesses (BLT). It can be learned from analysis of a stress emulation result that, when the thickness (BLT) of the bonding layer (Ag layer) reaches at least 30 µm, shear stress between the bonding layer (Ag layer) and a metal flange is much lower (50% to 80%) than stress generated when the thickness of the bonding layer is 10 µm or 20 µm. When the thickness of the bonding layer (Ag layer) is 10 µm, stress is 6 MPa to 7 MPa. When the thickness of the bonding layer (Ag layer) is 20 µm, stress is 3.8 MPa to 4.2 MPa. When the thickness of the bonding layer (Ag layer) is 30 µm, stress is only 1.8 MPa to 2.6 MPa. Therefore, increase of the thickness of the bonding layer (Ag layer) can reduce the shear stress between the bonding layer and the metal flange, thereby resolving a reliability problem such as stratification or cracking of the silver layer.

Maximum stress of the chip 20 is directly proportional to a thermal expansion difference, an ambient temperature difference, an elastic modulus of the silver bonding material, an elastic modulus of the substrate 10 (the metal flange), and a dimension of a long side of the chip 20, and is inversely proportional to the thickness of the bonding layer 30 (sintered silver).

It can be learned from comprehensive analysis of a stress emulation result and model that, in the embodiments of the present invention, the thickness of the bonding layer 30 needs to be at least 25 µm.

### (2) A stress emulation test of the substrate 10 on which the groove 12 is disposed

Stress emulation of the substrate 10 on which the groove 12 is designed is compared with stress emulation of the substrate 10 on which no groove 12 is designed. A maximum value of central stress of the substrate 10 on which the groove 12 is designed is 150 MPa, and a maximum stress value of the substrate 10 on which no groove 12 is designed is greater than 400 MPa. It can be learned through comparison that stress of a package structure in which the groove 12 is designed is reduced by at least 60%; and design of the groove 12 is conducive to even stress distribution of the entire chip 20, and there is no local stress peak, thereby helping resolve a reliability problem such as stratification or cracking of the silver bonding material.

A package structure manufacture method provided in the present invention includes the following steps:
As shown in FIG. 2, a groove 12 is first disposed on a substrate 10, and then an insulation layer 70 and a pin 50 are installed on the substrate 10.

As shown in FIG. 3, a silver bonding material is disposed on the substrate 10 to form a bonding layer, and a chip 20 is bonded to the substrate by using the bonding layer.

As shown in FIG. 4, a coating 40 and an auxiliary coating 90 are disposed. The coating 40 covers a surface that is of the bonding layer 30 and that is not in contact with the substrate 10 or the chip 20, and is used to prevent migration of silver ions in the bonding layer 30 that is caused because vapor enters the bonding layer 30. The auxiliary coating 90 is disposed on an extension path between the bonding layer 30 and the pin 50, and the coating 40 is located between the auxiliary coating 90 and the bonding layer 30. The auxiliary coating 90 is used to further prevent, with the help of the coating 40, the silver ions in the bonding layer 30 from migrating to the pin 50 along the extension path between the bonding layer 30 and the pin 50. Specifically, the auxiliary coating 90 is located at a junction of an inner surface of the insulation layer 70 and the substrate 10.

As shown in FIG. 5, a bonding wire 60 is disposed, to electrically connect the chip 20 to the pin 50. Then, a cover 80 is installed, and the cover 80 is connected to the substrate 10. The cover 80 and the substrate 10 jointly form accommodation space, the chip 20 is accommodated in the accommodation space, and the pin 50 protrudes from the cover 80.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A package structure, comprising a substrate, a chip, a bonding layer, and a coating, wherein
a plurality of grooves are disposed on the substrate;
silver bonding materials are disposed in the plurality of grooves and on a surface of the substrate, to form the bonding layer;
the chip is connected to the substrate by using the bonding layer;
the plurality of grooves are symmetrically arranged along a first axis of symmetry and a second axis of symmetry that are perpendicular to each other, a vertical projection of the chip on the substrate is centrosymmetric about the first axis of symmetry and the second axis of symmetry, a groove in the plurality of grooves that faces a periphery of the chip is an outer-ring groove, and the vertical projection of the chip on the substrate covers a partial area of the outer-ring groove; and
the coating covers a surface that is of the bonding layer and that is not in contact with the substrate or the chip, and is used to prevent migration of silver ions in the bonding layer.

2. The package structure according to claim 1, wherein the bonding layer is even in thickness, and being even in thickness means that the silver bonding materials that are symmetrically distributed along the first axis of symmetry and the second axis of symmetry are the same in thickness.

3. The package structure according to claim 2, wherein that the bonding layer is even in thickness comprises:
a bonding material that is of the bonding layer and that is located in a vertical projection area of the chip is even in thickness; and
a bonding material that is of the bonding layer and that is on a side of the chip is even in climbing height.

4. The package structure according to any one of claims 1 to 3, wherein a dimension of the bonding layer in a direction perpendicular to the substrate is at least 25 µm.

5. The package structure according to any one of claims 1 to 4, wherein the chip comprises a top surface, a bottom surface, and a side surface connecting the top surface to the bottom surface, the side surface comprises a step surface, the coating covers the step surface, and the step surface is used to increase a coverage area of the coating and prolong a migration path of the silver ions in the bonding layer.

6. The package structure according to claim 5, wherein a size of the top surface is less than a size of the bottom surface, the step surface faces the top surface, and a vertical distance between the top surface and the bottom surface is greater than 1 µm.

7. The package structure according to claim 5, wherein a size of the top surface is greater than a size of the bottom surface, the step surface faces the substrate, and a vertical distance between the top surface and the bottom surface is greater than 1 µm.

8. The package structure according to any one of claims 1 to 7, further comprising a pin configured to connect to an external circuit, wherein the chip is electrically connected to the pin by using a bonding wire, the pin comprises a gate electrode and a drain electrode, and the gate electrode and the drain electrode are respectively located on two opposite sides of the package structure.

9. The package structure according to claim 8, wherein an auxiliary coating is further disposed on the surface of the substrate, the auxiliary coating is disposed on an extension path between the bonding layer and the pin, and the coating is located between the auxiliary coating and the bonding layer.

10. The package structure according to claim 1, wherein there are a plurality of outer-ring grooves , the vertical projection of the chip on the substrate is a quadrilateral, and each side of the quadrilateral corresponds to at least three outer-ring grooves .

11. The package structure according to claim 10, wherein sizes of grooves corresponding to four angles of the quadrilateral each are greater than a size of another groove in the outer-ring grooves .

12. The package structure according to claim 1, wherein there are four outer-ring grooves , the vertical projection of the chip on the substrate is a quadrilateral, and the outer-ring grooves respectively correspond to four angles of the quadrilateral.

13. The package structure according to claim 1, wherein the groove corresponding to a central area of the chip is a central groove, the outer-ring groove is an annular groove, and the annular groove surrounds the central groove.

14. The package structure according to any one of claims 1 to 13, wherein a depth of each groove is at least 5 µm, and the depth of the groove is an extension dimension of the groove in a direction perpendicular to the installation surface.

15. The package structure according to claim 14, wherein a distance between adjacent grooves is 100 µm to 200 µm.

16. The package structure according to claim 1, wherein the package structure is a power amplifier.

17. A communications device, comprising the package structure according to any one of claims 1 to 16, a small radio frequency component, and a radio frequency passive component, wherein the package structure is a power amplifier, and is connected between the radio frequency small signal component and the radio frequency passive component.

18. The communications device according to claim 17, wherein the communications device is a remote radio unit in a base station.
